# EUROPÄISCHE PATENTSCHRIFT

(11) **EP 4 400 922 B1**
(45) Veröffentlichungstag und Bekanntmachung des Hinweises auf die Patenterteilung: **10.09.2025**
(21) Anmeldenummer: 23151077.7
(22) Anmeldetag: 11.01.2023
(51) Int. Cl.: G05B 19/00, G08C 19/00, H04L 12/00, H04Q 9/00

(54) **FELDGERÄT MIT FUNKMODUL UND VERFAHREN ZUR DATENFERNÜBERTRAGUNG**
FIELD DEVICE WITH RADIO MODULE AND METHOD FOR REMOTE DATA TRANSMISSION
APPAREIL DE TERRAIN AVEC MODULE RADIO ET PROCÉDÉ DE TRANSMISSION DE DONNÉES À DISTANCE

(43) Veröffentlichungstag der Anmeldung: 17.07.2024
(73) Patentinhaber: VEGA Grieshaber KG, 77709 Wolfach (DE)
(72) Erfinder: Mellert, Martin, 77790 Steinach (DE); Waldecker, Natalie, 79365 Rheinhausen (DE); Müller, Robin, 77796 Mühlenbach (DE)
(74) Vertreter: Patentanwälte Bauer Vorberg Kayser

(56) Entgegenhaltungen:
- DE-A1- 102010 043 031
- US-A1- 2005 017 908
- US-A1- 2009 224 730

## Beschreibung

Die Erfindung betrifft ein Feldgerät mit einem in einem Gehäuse aufgenommenen Funkmodul zur Datenfernübertragung sowie ein Verfahren zur Datenfernübertragung mittels eines in einem Gehäuse eines Feldgeräts aufgenommenen Funkmoduls.

In der Prozessautomatisierungstechnik werden vielfach Feldgeräte eingesetzt, die zur Erfassung und/oder Beeinflussung von Prozessvariablen dienen. Beispiele für derartige Feldgeräte sind Füllstand-, Grenzstand-, Durchfluss-, Druck-, Temperaturmessgeräte und dergleichen mit Sensoren, die die entsprechenden Prozessvariablen Füllstand, Grenzstand, Durchfluss, Druck, Temperatur etc. erfassen. Häufig sind solche Feldgeräte mit übergeordneten Einheiten, zum Beispiel Leitsystemen oder Steuereinheiten, per Datenfernübertragung verbunden. Diese übergeordneten Einheiten dienen zur Prozesssteuerung, Prozessvisualisierung und/oder Prozessüberwachung. Die Datenfernübertragung kann sowohl leitungsgebunden als auch drahtlos erfolgen.

Häufig werden Feldgeräte mit metallischen Gehäusen aufgrund ihrer mechanischen Stabilität und Resistenz gegenüber Umwelteinflüssen eingesetzt. Bei dem Einsatz von Feldgeräten in explosionsgefährdeten Umgebungen müssen diese bestimmte Anforderungen erfüllen, die den Einsatz von metallischen Gehäusen ebenfalls erfordern. Öffnungen des Gehäuses sind hierbei so beschaffen, dass eine Übertragung der Explosion aus dem Gehäuse verhindert wird. Sämtliche Verschlüsse und Durchführungen des Gehäuses sind entsprechend auszuführen und daher zum Teil sehr aufwändig zu gestalten.

Es ist bekannt, zur leichteren Bedienung und Parametrierung von Feldgeräten Funkmodule zu verwenden. Eine Bedienung und Parametrierung über Funkmodule erleichtert dem Bedienpersonal die Arbeit vor Ort, da das Feldgerät bspw. zur Parametrierung nicht geöffnet und dafür ggf. vollständig außer Betrieb genommen werden muss. Ebenso können die Funkmodule zur drahtlosen Datenfernübertragung mit einer übergeordneten Einheit verwendet werden.

Eine Verwendung von Funkmodulen steht aber im Widerspruch zu Gehäusen aus Metall. Befindet sich ein Funk-Sender/Empfänger zusammen mit der übrigen Sensorelektronik eines Feldgeräts (z. B. Füllstand- oder Drucksensor) innerhalb des Feldgerätegehäuses, so verhindern metallische Gehäusewandungen die Ausbreitung elektromagnetischer Wellen und damit die gewünschte Funkverbindung.

Die Ausbreitung elektromagnetischer Wellen kann unabhängig von dem gewählten Gehäusewerkstoff ebenfalls durch ein das Feldgerät wenigstens teilweise umgebendes Medium, in welches das Feldgerät zum Beispiel eingetaucht ist, verhindert oder zumindest erheblich gestört werden. Zum Beispiel kann das Medium Wasser, Öl o. ä. (d. h. fließfähig) sein, welches die elektromagnetische Strahlungsausbreitung erheblich behindert. Auch schüttfähige Medien wie beispielsweise Metall- oder metallhaltiges Pulver, Granulat oder eine Kombination aus schütt- und fließfähigen Medien, welche das Feldgerät teilweise oder vollständig umgeben, können eine gewünschte Funkverbindung erheblich einschränken oder vollständig verhindern.

Die Patentanmeldung DE 10 2010 043 031 A1 offenbart ein Feldgerät der Prozessautomatisierungstechnik gemäß dem Stand der Technik.

Vor diesem Hintergrund liegt der Erfindung die Aufgabe zugrunde, ein Feldgerät mit einem Funkmodul zur Datenfernübertragung sowie ein Verfahren zur Datenfernübertragung mittels eines derartigen Feldgeräts bereitzustellen, welches die aus dem Stand der Technik bekannten Nachteile überwindet. Insbesondere sollen das Feldgerät sowie das Datenfernübertragungsverfahren eine zuverlässige Datenübertragung ermöglichen, eine hohe Betriebssicherheit aufweisen, darüber hinaus benutzerfreundlich sowie wartungsarm und nicht zuletzt kostengünstig in der Herstellung bzw. Implementierung sein.

Diese Aufgabe wird durch ein Feldgerät mit den Merkmalen des Anspruchs 1 sowie durch ein Verfahren mit den Merkmalen des Anspruchs 10 gelöst. Weitere, besonders vorteilhafte Ausgestaltungen der Erfindung offenbaren die jeweiligen Unteransprüche.

Es ist darauf hinzuweisen, dass die in den Ansprüchen einzeln aufgeführten Merkmale in beliebiger, technisch sinnvoller Weise miteinander kombiniert werden können (auch über Kategoriegrenzen, beispielsweise zwischen Verfahren und Vorrichtung, hinweg) und weitere Ausgestaltungen der Erfindung aufzeigen. Die Beschreibung charakterisiert und spezifiziert die Erfindung insbesondere im Zusammenhang mit den Figuren zusätzlich.

Es sei ferner angemerkt, dass eine hierin verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Außerdem soll ein hierin verwendeter Begriff "etwa" einen Toleranzbereich angeben, den der auf dem vorliegenden Gebiet tätige Fachmann als üblich ansieht. Insbesondere ist unter dem Begriff "etwa" ein Toleranzbereich der bezogenen Größe von bis maximal +/-20 %, bevorzugt bis maximal +/-10 % zu verstehen.

Erfindungsgemäß weist ein Feldgerät, beispielsweise ein Füllstand-, Grenzstand-, Durchfluss-, Druck-, Temperaturmessgerät o. ä., ein Gehäuse, eine durch eine Kabeldurchführung in das Gehäuse geführte elektrische Anschlussleitung und ein im Gehäuse aufgenommenes Funkmodul zur Datenfernübertragung auf. Das Funkmodul ist derart angeordnet und ausgebildet, ein Datenfernübertragungssignal vermittels einer Feldkopplung mit einem im Gehäuse liegenden Abschnitt der Anschlussleitung in einen außerhalb des Gehäuses liegenden Abschnitt der Anschlussleitung zu übertragen und/oder von diesem zu empfangen.

Der im Gehäuse liegende Abschnitt der Anschlussleitung wird hierin der Einfachheit halber auch als innenliegender Leitungsabschnitt bezeichnet und der außerhalb des Gehäuses liegende Abschnitt der Anschlussleitung auch als außenliegender Leitungsabschnitt.

Die elektrische Anschlussleitung kann beispielsweise zur Stromversorgung des Feldgeräts dienen, zu seiner Erdung o. ä. Die Anschlussleitung weist dementsprechend wenigstens eine elektrisch leitende Ader auf.

Als Feldkopplung kann im weitesten Sinne eine elektrisch berührungsfreie, d. h. nicht galvanisch verbundene, Kopplung zweier elektronischer Komponenten über ein elektrisches, magnetisches oder elektromagnetisches Feld (d. h. elektromagnetische Strahlung) verstanden werden, wobei die Feldkopplung gemäß der Erfindung dazu ausgebildet ist, die Übertragung des Datenfernübertragungssignals zwischen dem Funkmodul und dem innenliegenden Abschnitt der Anschlussleitung zu gewährleisten. Das Funkmodul kann im einfachsten Fall für eine unidirektionale Datenfernübertragung (d. h. entweder nur senden oder nur empfangen) ausgebildet sein. Eine bidirektionale Datenfernübertragung (d. h. sowohl senden als auch empfangen) ist ebenfalls möglich.

Die Erfindung ermöglicht eine über den innen- und außenliegenden Abschnitt der Anschlussleitung geführte Datenfernübertragung bzw. Datenkommunikation mit dem Feldgerät, wobei sich ein Kommunikationspartner vom Feldgerät räumlich entfernt befindet. Unabhängig von dem Medium, welches das Feldgerät teilweise oder vollständig umgibt, kann die Datenfernübertragung über die Anschlussleitung aus dem Feldgerätegehäuse (und ggfs. aus dem Medium) nach außen geführt werden.

Das Datenfernübertragungssignal kann an einem Teilstück der außenliegenden Anschlussleitung abgegriffen werden. Hierunter ist zu verstehen, dass ein galvanischer (d. h. elektrisch kontaktbehafteter) Abgriff erfolgen kann, um das elektrische Signal auf der Anschlussleitung zu detektieren (d. h. zu empfangen) bzw. in diese einzuspeisen (d. h. zu senden). Der Abgriff kann alternativ elektrisch berührungsfrei mittels einer Feldkopplung zwischen dem Abgriffsteilstück des außenliegenden Anschlusskabels und dem räumlich entfernten Empfänger bzw. Sender erfolgen, also im weitesten Sinne durch eine Signal- bzw. Datenübertragung unter Verwendung eines elektrischen, magnetischen oder elektromagnetischen Feldes (d. h. durch elektromagnetische Strahlung). Die Feldkopplung am außenliegenden Leitungsabschnitt kann ähnlich ausgebildet sein wie die Feldkopplung zwischen dem Funkmodul und dem innenliegenden Leitungsabschnitt, ohne jedoch zwingend hierauf beschränkt zu sein. Die außenliegende Feldkopplung kann ebenso nach einem anderen Übertragungsprinzip ausgebildet sein als die innenliegende Feldkopplung.

Falls die außenliegende Anschlussleitung eine Leitungsisolierung (z. B. Kunststoffisolierung) aufweist, ist das für den Abgriff vorgesehene Teilstück der Anschlussleitung vorzugsweise nicht isoliert, unabhängig davon, ob der Abgriff oder die Einspeisung des Datenfernübertragungssignals an der außenliegenden Anschlussleitung galvanisch oder durch Feldkopplung erfolgt.

Der außenliegende Leitungsabschnitt kann auch mehrere Teilstücke aufweisen, an denen das Datenfernübertragungssignal abgegriffen oder eingespeist werden kann.

Als Abgreifen des Datenfernübertragungssignals ist hierin sowohl ein Auskoppeln (d. h. empfangen) des Signals von der Anschlussleitung als auch ein Einkoppeln (d. h. senden) eines Datenfernübertragungssignals von einem gehäuseaußenseitigen Sender zu verstehen, um das Datenfernübertragungssignal zwischen dem innenliegenden Leitungsabschnitt und dem außenliegenden Leitungsabschnitt zu übertragen. Auf diese Weise kann eine bidirektionale Datenübertragung zwischen dem feldgeräteexternen Send/Empfänger und dem Funkmodul bzw. Feldgerät realisiert sein.

Die Erfindung ermöglicht u. a. eine benutzer- und anwendungsfreundliche Bedienung und Parametrierung des Feldgeräts über das Funkmodul, da das Feldgerät hierfür nicht geöffnet und ggf. außer Betrieb genommen werden muss. Das Feldgerät kann während des Bedienungs- bzw. Parametriervorgangs an Ort und Stelle verbleiben. Es ist dabei unerheblich, ob das Feldgerät bereits in einem Medium (z. B. Wasser, Öl, Granulat, Pulver etc.) eingetaucht bzw. von diesem umgeben ist oder noch ohne Kontakt mit dem Medium ist. Ebenso kann das Feldgerätegehäuse aus einem Metallwerkstoff gebildet sein, ohne die Datenfernübertragung im Wesentlichen zu beeinträchtigen. Hierin ist ein besonderer Vorteil der Erfindung zu sehen. Jedoch sind Feldgerätegehäuse aus einem nichtmetallischen Werkstoff, wie z. B. Kunststoff, keinesfalls ausgeschlossen und können alternativ oder ergänzend zu einem Metallgehäuse verwendet werden. Ebenso kann das Feldgerät mittels der hierin offenbarten Datenfernübertragung während des bestimmungsgemäßen Betriebs Messwerte an den externen Empfänger/Sender (z. B. übergeordnete Leitstelle o. ä.) übertragen.

Weiterhin stellt die Erfindung ein kompakt bauendes Feldgerät bereit, in dem das Funkmodul vollständig integriert sein kann und das Datenfernübertragungssignal über die Anschlussleitung übertragen wird.

Es ist zu verstehen, dass ein beispielhaft als Füllstand-, Grenzstand-, Durchfluss-, Druck- oder Temperaturmessgerät ausgebildetes Feldgerät jeweils auch einen entsprechenden Messwertaufnehmer zur Erfassung eines Füllstands, Grenzstands, Durchflusses, Drucks bzw. Temperatur aufweist.

Erfindungsgemäß ist die Feldkopplung als elektromagnetische Strahlungskopplung ausgebildet ist.

Strahlungskopplung bezeichnet den Vorgang, dass ein elektromagnetisches Feld auf die bei der Kopplung beteiligten elektrischen/elektronischen Komponenten einwirkt. Elektrische Leiter eines Kabels oder auf Leiterplatten können als Antenne wirken und Funksignale empfangen oder aussenden. Die Strahlungskopplung kann zwischen Kabel-Kabel, Feld-Kabel oder Antenne-Antenne auftreten und im hierin offenbarten Sinn zur Übertragung des Datenfernübertragungssignal zwischen dem Funkmodul und dem innenliegenden Leitungsabschnitt der Anschlussleitung genutzt werden.

Die Feldkopplung zwischen dem Funkmodul und dem innenliegenden Leitungsabschnitt der Anschlussleitung bietet den besonderen Vorteil, dass das Funkmodul einschließlich einer Antenne für die drahtlose Datenübertragung vollständig im Feldgerätegehäuse angeordnet und aufgenommen sein kann. Die Feldkopplung kann durch entsprechende Anordnung und Ausbildung der Antenne und des innenliegenden Leitungsabschnitts realisiert sein. Die Feldkopplung kann damit ohne zusätzliche Komponenten und ohne spezielle Koppelschaltungen (z. B. Schaltungsnetzwerke mit Widerständen, Kondensatoren, Spulen und dergleichen) realisiert sein.

Beispielsweise können die Antenne und der innenliegende Kopplungsabschnitt der Anschlussleitung als parallel geführte Leiter oder parallelgeführte Leiterbahnen auf einer Leiterplatte ausgebildet sein, ohne jedoch zwingend hierauf beschränkt zu sein. Die Antenne und der der zur Kopplung vorgesehen innenliegende Leitungsabschnitt können ebenso als Leiterschleifen ausgebildet sein.

In diesem Sinn sieht eine vorteilhafte Weiterbildung des Erfindungsgegenstands vor, dass das Funkmodul eine in dem Gehäuse angeordnete Antenne aufweist, wobei die Antenne und der innerhalb des Gehäuses liegende Abschnitt der Anschlussleitung für die wechselseitige Feldkopplung ausgebildet und angeordnet sind. Bevorzugt ist das Funkmodul beispielsweise für die Verwendung von NFC-, RFID-, DECT-, WiFi/WLAN- oder Bluetooth-Funkübertragungstechniken ausgebildet, ohne zwingend nur auf diese Techniken beschränkt zu sein. Es versteht sich, dass andere Funkübertragungstechniken ebenfalls verwendet werden können und die vorstehende Aufzählung lediglich beispielgebend, nicht jedoch als abschließend zu verstehen ist. Die Antenne des Funkmoduls ist vorzugsweise vollständig in dem Gehäuse aufgenommen. Die Antenne und der innenliegende Abschnitt der Anschlussleitung können zum Beispiel als parallel geführte Leiter oder parallelgeführte Leiterbahnen auf einer Leiterplatte ausgebildet und angeordnet sein, wobei andere Ausgestaltungen und Anordnungen der Antenne und des innenliegenden Leitungsabschnitts, die im Wesentlichen dasselbe Ziel erreichen, nicht ausgeschlossen sind.

Jedenfalls koppelt das im Feldgerät eingebaute Funkmodul (z. B. Bluetooth-Modul) das Funksignal bzw. Datenfernübertragungssignal in den innenliegenden Leitungsabschnitt der Anschlussleitung ein (d. h. senden) oder aus diesem aus (d. h. empfangen). Das Signal kann beispielsweise an einem offenen, nicht isolierten Ende der Anschlussleitung oder einem Teilstück der Anschlussleitung ohne Abschirmung in der hierin offenbarten Weise abgegriffen werden.

Um die Datenfernübertragung unempfindlicher gegen äußere Störeinflüsse zu gestalten, weist der außerhalb des Gehäuses liegende Abschnitt der Anschlussleitung nach einer bevorzugten Weiterbildung eine quer- und/oder längswasserdichte Isolierung auf. Die Isolierung kann beispielsweise aus einem Kunststoff gebildet sein.

Bei einer querwasserdichten Isolierung kann ein flüssiges Medium wie beispielsweise Wasser, Öl o. ä. die Isolierung nicht durchdringen und dementsprechend nicht zur elektrisch leitenden, für die Übertragung des Datenfernübertragungssignals genutzte elektrische Ader der Anschlussleitung gelangen. Eine Längswasserdichtung verhindert, dass ein flüssiges Medium wie beispielsweise Wasser, Öl und dergleichen über freie Enden der Isolierung oder im Falle einer Beschädigung der Isolierung auch zwischen zwei freien Endabschnitten zwischen die Isolierung eindringt. Das Vordringen des flüssigen Mediums in andere Bereiche der Anschlussleitung wird bei einer Längswasserdichtung ebenfalls unterbunden.

In beiden Fällen, d. h. quer- und/oder längswasserdichte Isolierung, wird eine Dämpfung des Datenfernübertragungssignals in der Anschlussleitung infolge eines Kontakts der Anschlussleitung bzw. elektrischen Ader mit dem flüssigen Medium verhindert.

Der Begriff "wasserdicht" soll nicht auf eine Dichtwirkung lediglich gegenüber dem Medium Wasser beschränkt sein. Vielmehr ist eine Dichtungswirkung der Isolierung gegenüber all jenen Medien zu verstehen, mit denen die Anschlussleitung bei der bestimmungsgemäßen Verwendung des Feldgeräts in Kontakt kommen kann und welche insbesondere eine nachteilige (z. B. dämpfende) Wirkung auf die Übertragungsleistung des Datenfernübertragungssignals über die Anschlussleitung bewirken. Diese Medien können sowohl fließfähig wie zum Beispiel Wasser, Öl o. ä., aber auch schüttfähig sein wie beispielsweise körnige oder pulverförmige Medien.

Die Kabeldurchführung kann bevorzugt als fluiddichte Anbindung der Anschlussleitung an das Gehäuse ausgebildet sein.

Wie bereits an anderer Stelle erwähnt, kann der außerhalb des Gehäuses liegende Abschnitt der Anschlussleitung gemäß einer Ausgestaltung der Erfindung wenigstens ein isolierungsfreies Teilstück zur Auskopplung und/oder Einkopplung des Datenfernübertragungssignals aufweisen. An diesem Teilstück kann das Datenfernübertragungssignal galvanisch, kapazitiv, induktiv oder durch elektromagnetische Strahlungskopplung von einem feldgeräteexternen Empfänger abgegriffen bzw. einem externen Sender eingespeist werden. Damit ist eine räumlich getrennte Abgriffmöglichkeit bzw. sind bei Bereitstellung mehrerer isolierungsfreier Teilstücke mehrere Abgriffmöglichkeiten für einen oder mehrere externe Sender/Empfänger gegeben.

In vorteilhafter Weiterbildung des Erfindungsgegenstands weist das Gehäuse eine elektromagnetisch wirksame Gehäuseschirmung auf. Die Gehäuseschirmung kann einerseits eine Konzentration des Feldes zwischen dem Funkmodul (z. B. Antenne) und dem innenliegenden Leitungsabschnitt der Anschlussleitung bewirken. Zusätzlich kann die Gehäuseschirmung das Einstrahlen von externen Störfeldern in das Gehäuse unterbinden oder zumindest deutlich abschwächen. Die Gehäuseschirmung kann aus einem elektrisch leitenden Material gebildet sein. Beispielsweise kann ein Kunststoffgehäuse eine metallische Beschichtung aufweisen. Diese kann auf der Außen- und/oder Innenseite des Gehäuses angebracht oder in Gehäusewandungen eingebettet sein.

Das Gehäuse kann auch teilweise oder vollständig aus einem Metallwerkstoff gebildet sein, der eine Schirmungsfunktion alternativ oder zusätzlich zur einer Gehäusebeschichtung bereitstellen kann. Beispielsweise kann das Gehäuse einen vollverschweißten Metallaufbau aufweisen.

Je nach konkreter Ausbildung und Einsatzzweck des Feldgeräts kann es erforderlich sein, das Gehäuse nicht vollumfänglich geschlossen und/oder vollumfänglich metallisch auszubilden, beispielsweise um die von einem Messwertaufnehmer zu erfassende physikalische Größe nicht ebenfalls abzuschirmen oder abzuschwächen.

Ein Messwertaufnehmer ist hierin allgemein als ein Teil des Feldgeräts zu verstehen, welcher auf die zu messende Größe unmittelbar reagiert bzw. anspricht.

In dem vorliegenden Fall kann ein Fenster in dem Gehäuse des Feldgeräts vorgesehen sein, durch welches der Messwertaufnehmer die physikalische Größe im Wesentlichen ungestört detektieren kann. Um dennoch die vorbeschriebene Schirmungswirkung und/oder Feldkopplungskonzentration zu erzielen, kann in dem Fall, dass das Feldgerät einen nichtmetallischen Messwertaufnehmer aufweist, beispielsweise einen keramischen Druckaufnehmer, dieser gehäuseinnenseitig mit einer metallischen Messelektrode belegt sein. Die Messelektrode dient der Umwandlung der von dem Messwertaufnehmer erfassten physikalischen Größe in eine geeignete elektrische Größe (z. B. Strom, Spannung). Zugleich wird die Messelektrode in vorteilhafter Weise zur elektromagnetischen Schirmung und/oder zur Feldkonzentration verwendet.

Weiterhin bevorzugt kann der außerhalb des Gehäuses liegende Abschnitt der Anschlussleitung eine elektromagnetisch wirksame Leitungsschirmung aufweisen. Diese kann über die gesamte Länge des außenliegenden Leitungsabschnitts vorgesehen sein, um eine Einkopplung externer Störsignale direkt in die außenliegende Anschlussleitung zu unterbinden.

Eine Länge des außerhalb des Gehäuses liegenden Abschnitts der Anschlussleitung kann wenigstens etwa 2 m betragen, bevorzugt wenigstens etwa 3 m, noch bevorzugter wenigstens etwa 5 m. Die maximale Länge des außerhalb des Gehäuses liegenden Abschnitts der Anschlussleitung beträgt vorzugsweise höchstens einige wenige hundert Meter, z. B. etwa 100 bis 500 m, vorzugsweise höchstens etwa 50 bis 100 m, noch bevorzugter höchstens etwa 15 bis 50 m. Es hat sich herausgestellt, dass auf diese Weise eine zuverlässige Übertragung des Datenfernübertragungssignals zwischen dem gehäuseinnenseitigen Funkmodul 6 und einem am außenliegenden Abschnitt 10 der Anschlussleitung 5 angekoppelten Sender/Empfänger erzielt werden kann. Die vorstehenden Längenangaben der äußeren Anschlussleitung geben insbesondere die zur Datenfernübertragung des Datenfernübertragungssignals genutzte Länge der äußeren Anschlussleitung an, d. h. im Wesentlichen eine Länge vom gehäuseseitigen Ende des außerhalb des Gehäuses liegenden Abschnitts der Anschlussleitung bis zu einem am weitesten vom Gehäuse entfernten Abgriffsteilstück der Anschlussleitung. Bei einem berührungsfreien Abgriff können Übertragungsdistanzen mittels der erfindungsgemäßen Datenfernübertragung von der Anschlussleitung (d. h. von einem Abgriffsteilstück der Anschlussleitung) bis zu einem Sender/Empfänger von einigen Zentimetern, z. B. 10 cm bis 50 cm, bis zu einigen Metern, z. B. bis zu etwa 10 m bis 15 m, erzielt werden.

Des Weiteren sieht eine andere vorteilhafte Ausgestaltung des Erfindungsgegenstands vor, dass die Anschlussleitung als Tragkabel ausgebildet ist, an dem das Gehäuse in betriebsgemäßem Zustand des Feldgeräts hängend gehalten ist. Beispielsweise kann das Feldgerät als Hängedruckmessgerät ausgebildet sein, das mittels der Anschlussleitung am Einsatzort aufgehängt ist. Selbstverständlich ist die Ausgestaltung als Tragkabel nicht auf Druckmessgeräte beschränkt. So kann ein Füllstand- oder Grenzstandmessgerät über die als Tragkabel ausgebildete Anschlussleitung in einem Behälter hängend angeordnet sein, in dem sich ein zu überwachendes Medium befindet. Ebenso können auch andere Feldmessgeräte wie Durchfluss-, Temperaturmessgeräte usw. mittels ihrer Anschlussleitung als Tragkabel betriebsgemäß aufgehängt sein.

Gemäß einem weiteren Aspekt der Erfindung wird ein Verfahren zur Datenfernübertragung mittels eines in einem Gehäuse eines Feldgeräts aufgenommenen Funkmoduls über eine durch eine Kabeldurchführung in das Gehäuse geführte elektrische Anschlussleitung offenbart, wobei ein Datenfernübertragungssignal vermittels einer Feldkopplung des Funkmoduls mit einem im Gehäuse liegenden Abschnitt der Anschlussleitung in einen außerhalb des Gehäuses liegenden Abschnitt der Anschlussleitung übertragen und/oder von diesem empfangen wird.

Es ist zu verstehen, dass bezüglich verfahrensbezogener Begriffsdefinitionen sowie der Wirkungen und Vorteile verfahrensgemäßer Merkmale vollumfänglich auf die Offenbarung sinngemäßer Definitionen, Wirkungen und Vorteile der erfindungsgemäßen Vorrichtung zurückgegriffen werden kann. Entsprechend können Offenbarungen hierin bezüglich der erfindungsgemäßen Vorrichtung in sinngemäßer Weise ebenso zur Definition des erfindungsgemäßen Verfahrens herangezogen werden, so dass an dieser Stelle auf eine Wiederholung von Erläuterungen sinngemäß gleicher Merkmale, deren Wirkungen und Vorteile zugunsten einer kompakteren Beschreibung verzichtet wird, ohne dass derartige Auslassungen als Einschränkung auszulegen wären.

Nach dem erfindungsgemäßen Verfahren ist die Feldkopplung durch elektromagnetische Strahlung ausgeführt.

Nach einer bevorzugten Weiterbildung der Erfindung wird das Datenfernübertragungssignal an wenigstens einem Teilstück des außerhalb des Gehäuses liegenden Abschnitts der Anschlussleitung durch galvanische, kapazitive und/oder induktive Kopplung und/oder durch elektromagnetische Strahlungskopplung ausgekoppelt und/oder eingekoppelt.

Eine weiterhin bevorzugte Ausgestaltung des Verfahrens sieht vor, dass das Gehäuse über die als Tragkabel ausgebildete Anschlussleitung in betriebsgemäßem Zustand des Feldgeräts hängend gehalten wird.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird. In dieser Zeichnung zeigen schematisch:
- Fig. 1: ein Funktionsdiagramm eines Ausführungsbeispiels eines Feldgeräts gemäß der Erfindung,
- Fig. 2: eine Teilansicht eines ersten Beispiels einer möglichen Feldkopplung gemäß der Erfindung,
- Fig. 3: eine Teilansicht eines zweiten Beispiels einer möglichen Feldkopplung die nicht von den Ansprüchen abgedeckt ist,

- Fig. 4: eine Teilansicht eines dritten Beispiels einer möglichen Feldkopplung die nicht von den Ansprüchen abgedeckt ist,

- Fig. 5: ein Funktionsdiagramm eines weiteren Ausführungsbeispiels eines Feldgeräts gemäß der Erfindung und
- Fig. 6: ein Funktionsdiagramm eines noch weiteren Ausführungsbeispiels eines Feldgeräts gemäß der Erfindung.

In den unterschiedlichen Figuren sind hinsichtlich ihrer Funktion gleichwertige Teile stets mit denselben Bezugszeichen versehen, so dass diese in der Regel auch nur einmal beschrieben werden.

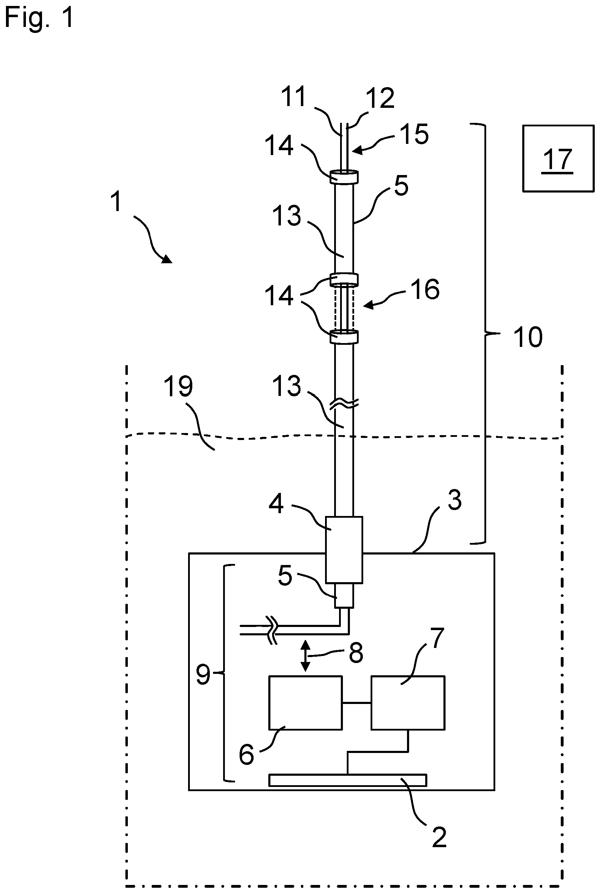

Fig. 1 stellt schematisch ein Funktionsdiagramm eines Ausführungsbeispiels eines Feldgeräts 1 gemäß der Erfindung dar. Das Feldgerät 1 kann ohne Beschränkung der Allgemeinheit beispielsweise als Füllstand-, Grenzstand-, Durchfluss-, Druck-, Temperaturmessgerät o. ä. ausgebildet sein, wobei es einen entsprechenden Messwertaufnehmer 2 zur Erfassung eines Füllstands, Grenzstands, Durchflusses, Drucks, Temperatur und dergleichen aufweist.

Der Messwertaufnehmer 2 ist allgemein als ein Teil des Feldgeräts 1 zu verstehen, welcher auf die zu messende Größe unmittelbar reagiert bzw. anspricht.

Fig. 1 ist zu entnehmen, dass das Feldgerät 1 ein Gehäuse 3 aufweist, eine durch eine Kabeldurchführung 4 in das Gehäuse 3 geführte elektrische Anschlussleitung 5 und ein im Gehäuse 3 aufgenommenes Funkmodul 6 zur Datenfernübertragung.

Das Funkmodul 6 ist bei dem in Fig. 1 gezeigten Beispiel mit einer elektronischen Steuereinheit 7 verbunden. Die Steuereinheit 7 kann einen Mikroprozessor, Mikrocontroller, DSP o. ä. sowie ggfs. Speicher wie z. B. RAM, ROM, Flash und dergleichen aufweisen. Bei dem in Fig. 1 gezeigten beispielhaften Feldgerät 1 steht die Steuereinheit 7 in Verbindung mit dem Messwertaufnehmer 2, um die vom Messwertaufnehmer 2 ausgegebenen elektronischen Signale zu empfangen und ggfs. zu verarbeiten und insbesondere mittels des Funkmoduls 6 zu übertragen. Ebenso kann das Feldgerät 1 bzw. die Steuereinheit 7 ausgebildet sein, über das Funkmodul 6 Daten zu empfangen, die beispielsweise zur Bedienung und Parametrierung des Feldgeräts 1 verwendet werden können.

Für die Datenfernübertragung ist das Funkmodul 6 im Feldgerät 1 derart angeordnet und ausgebildet, ein Datenfernübertragungssignal vermittels einer Feldkopplung 8 mit einem im Gehäuse 3 liegenden Abschnitt 9 der Anschlussleitung 5 in einen außerhalb des Gehäuses 3 liegenden Abschnitt 10 der Anschlussleitung 5 zu übertragen und/oder von diesem zu empfangen.

Wie Fig. 1 weiter zu entnehmen ist, weist die Anschlussleitung 5 vorliegend mehrere elektrische Adern 11, 12 auf, die zum Beispiel zur Stromversorgung des Feldgeräts 1 verwendet werden können, ohne jedoch zwingend auf die in Fig. 1 dargestellte Anzahl Adern oder auf den hier beschriebenen Verwendungszweck beschränkt zu sein. Es können mehr als die in Fig. 1 dargestellte Anzahl Adern oder weniger in der Anschlussleitung 5 vorhanden sein. Die Anschlussleitung 5 kann zusätzlich oder alternativ zur Erdung des Feldgeräts 1 verwendet werden. Ebenfalls ist es denkbar, eine separate Ader ausschließlich für die Datenfernübertragung mittels des Funkmoduls 6 vorzusehen.

Des Weiteren weist die Anschlussleitung 5 des in Fig. 1 gezeigten Feldgeräts 1 außerhalb des Gehäuses 3 eine quer- und längswasserdichte Isolierung 13 bzw. 14 auf, obwohl weder die querwasserdichte Isolierung 13 noch die längswasserdichte Isolierung 14 zwingend zur Verwirklichung der Erfindung vorgesehen sein müssen. Jedoch stellt zumindest die querwasserdichte Isolierung 13 eine bevorzugte Ausführung der Anschlussleitung 5 dar. Die Isolierung 13 kann durch eine Kunststoffummantelung der Anschlussleitung 5 gebildet sein. Der Begriff "wasserdicht" soll nicht auf eine Dichtwirkung lediglich gegenüber dem Medium Wasser beschränkt sein. Vielmehr ist eine Dichtungswirkung der Isolierung 13, 14 gegenüber all jenen Medien zu verstehen, mit denen die Anschlussleitung 5 bei der bestimmungsgemäßen Verwendung des Feldgeräts 1 in Kontakt kommen kann und die insbesondere eine nachteilige (z. B. dämpfende) Wirkung auf die Übertragungsleistung des Datenfernübertragungssignals über die Anschlussleitung 5 aufweisen. Diese Medien können sowohl fließfähig sein wie zum Beispiel Wasser, Öl o. ä., auch schüttfähig wie beispielsweise körnige oder pulverförmige Medien oder eine Kombination aus beiden Medienarten.

Die Kabeldurchführung 4 stellt bevorzugt eine fluiddichte Anbindung der Anschlussleitung 5 an das Gehäuse 3 dar.

Der innenliegende Abschnitt 9 der Anschlussleitung 5 ist nur teilweise und insoweit dargestellt, wie es zum Verständnis der Erfindung erforderlich ist. Es ist zu verstehen, dass beispielsweise die Steuereinrichtung 7 mit der Anschlussleitung 5 elektrisch verbunden sein kann, um zum Beispiel mit elektrischer Energie versorgt zu werden. Ggfs. weitere, in Fig. 1 nicht dargestellte elektrische/elektronische Komponenten des Feldgeräts 1 können mit der Anschlussleitung 5 in elektrischer Verbindung stehen.

Weiterhin kann Fig. 1 entnommen werden, dass der außerhalb des Gehäuses 3 liegende Abschnitt 10 der Anschlussleitung 5 wenigstens ein isolierungsfreies Teilstück, vorliegend beispielhaft zwei Teilstücke 15, 16 zur Auskopplung und/oder Einkopplung des Datenfernübertragungssignals aufweist. Das Teilstück 15 stellt vorliegend ein freies Ende der Verbindungsleitung 5 dar, das Teilstück 16 ein Zwischenstück der Anschlussleitung 5, das keine Isolierung aufweist. Selbstverständlich sind die Anzahl und Anordnung der Teilstücke 15, 16 nicht auf die in Fig. 1 gezeigte Form beschränkt. Es können weniger als zwei Teilstücke ohne Isolierung, aber auch mehr als zwei isolierungsfreie Teilstücke im außenliegenden Abschnitt 10 der Anschlussleitung 5 vorgesehen sein.

Das Datenfernübertragungssignal kann an den isolierungsfreien Teilstücken 15, 16 wahlweise abgegriffen werden. Hierunter ist zu verstehen, dass ein galvanischer (d. h. kontaktbehafteter) Abgriff vorgesehen sein kann, um das elektrische Signal auf der Anschlussleitung zu detektieren (d. h. zu empfangen) bzw. in diese einzuspeisen (d. h. zu senden). Der Abgriff kann alternativ auch elektrisch berührungsfrei mittels einer Feldkopplung (beispielsweise ähnlich der Feldkopplung 8) zwischen dem Teilstück 15, 16 und einem feldgeräteexternen Empfänger und/oder Sender 17 erfolgen, also im weitesten Sinne durch eine Signal- bzw. Datenübertragung unter Verwendung eines elektrischen, magnetischen oder elektromagnetischen Feldes (d. h. elektromagnetische Strahlung). Bei einem berührungsfreien Abgriff können Übertragungsdistanzen mittels der erfindungsgemäßen Datenfernübertragung von Abgriff 15 bzw. 16 bis zu einem Sender/Empfänger 17 von einigen Zentimetern, z. B. 10 cm bis 50 cm, bis zu einigen Metern, z. B. bis zu etwa 10 m bis 15 m, erzielt werden, ohne zwingend nur auf die konkrete Ausführungsform des Feldgeräts 1 aus Fig. 1 beschränkt zu sein.

Zusätzlich zur Isolierung 13 und/oder 14 kann die Anschlussleitung 5 bzw. wenigstens der außerhalb des Gehäuses 3 liegende Abschnitt 10 der Anschlussleitung 5 eine elektromagnetisch wirksame Leitungsschirmung (nicht dargestellt) aufweisen.

Der außenliegende Abschnitt 10 der Anschlussleitung 5 kann eine Länge von wenigstens etwa 2 m, bevorzugt wenigstens etwa 3 m, noch bevorzugter wenigstens etwa 5 m aufweisen und eine maximale Länge von höchstens etwa 50 m, bevorzugt höchstens etwa 25 m und noch bevorzugter höchstens etwa 15 m. Längen der Anschlussleitung 5, die im Bereich zwischen etwa 2 m und etwa 50 m liegen, sind hiervon ebenfalls umfasst. Je nach konkretem Anwendungsfall, zum Beispiel als Hängedrucksensor, kann der außenliegende Abschnitt 10 der Anschlussleitung 5 (d. h. der zur Datenfernübertragung genutzte äußere Abschnitt) durchaus auch Längen bis zu einigen wenigen hundert Metern aufweisen, z. B. etwa 100 m bis 500 m, wobei eine Maximallänge von höchstens etwa 50 bis 100 m oder auch weniger (z. B. höchstens etwa 15 m bis 50 m) besonders vorteilhaft sein kann, um eine zuverlässige Datenfernübertragung gemäß der Erfindung zu gewährleisten.

Wie Fig. 1 weiter entnommen werden kann, ist die Anschlussleitung 5 im vorliegenden Beispiel als Tragkabel ausgebildet, an dem das Gehäuse 3 in betriebsgemäßem Zustand des Feldgeräts 1 hängend gehalten ist. So kann das Feldgerät 1 zum Beispiel hängend in ein in einem Behälter befindliches Medium 19 (wenigstens teilweise) eingetaucht sein, wie in Fig. 1 durch gestrichelte bzw. strichpunktierte Linien angedeutet ist. Das Feldgerät 1 kann beispielsweise als Hängedrucksensor ausgebildet sein, ohne zwingend auf die konkrete Ausgestaltung als Drucksensor beschränkt zu sein. Das Feldgerät 1 kann ebenso als Füllstand-, Grenzstand-, Durchfluss-, Temperaturmessgeräte o. ä. ausgebildet sein und am Betriebsort über die Anschlussleitung 5 aufgehängt sein.

Die Feldkopplung 8 des Feldgeräts 1 kann als kapazitive und/oder induktive Kopplung und/oder als elektromagnetische Strahlungskopplung ausgebildet sein. Erfindungsgemäß ist die Feldkopplung als elektromagnetische Strahlungskopplung ausgebildet.

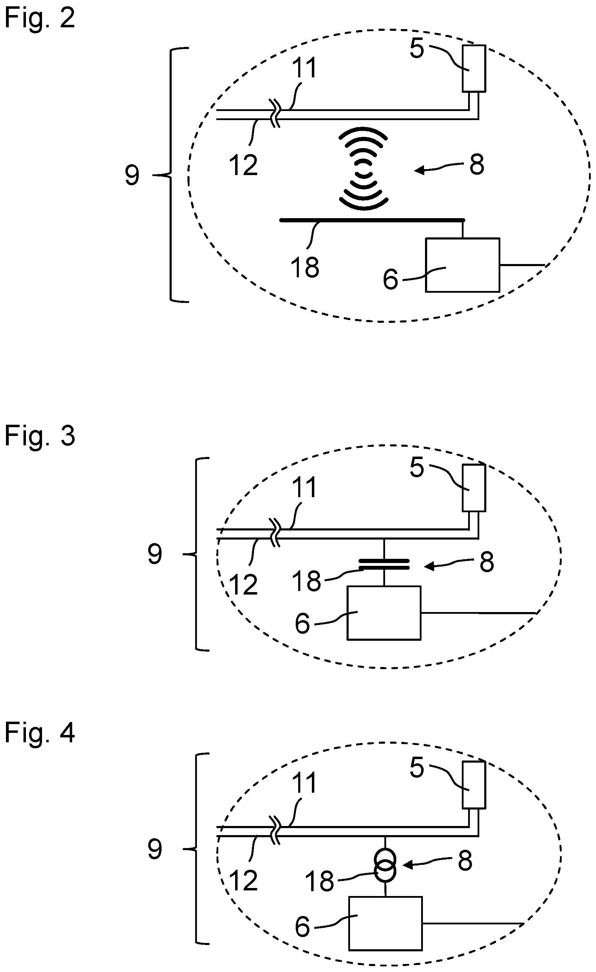

Die Fig. 2, 3 und 4 stellen jeweils schematisch Beispiele einer solchen Feldkopplung 8 in einer Teilansicht dar, wie sie im Feldgerät 1 der Fig. 1 verwendet werden kann, aber auch in möglichen weiteren Ausführungsformen eines Feldgeräts.

In Fig. 2 ist die Feldkopplung 8 schematisch in Form einer elektromagnetischen Strahlungskopplung dargestellt. Wie zu erkennen ist, wirkt bei der Strahlungskopplung ein elektromagnetisches Feld auf die bei der Kopplung beteiligten elektrischen/elektronischen Komponenten ein. Vorliegend sind das eine Antenne 18 des Funkmoduls 6 sowie der innenliegende Abschnitt 9 der Anschlussleitung 5 bzw. Adern 11 und/oder 12.

Die Feld- bzw. Strahlungskopplung zwischen dem Funkmodul 6 und dem innenliegenden Leitungsabschnitt 9 der Anschlussleitung 5 bietet den besonderen Vorteil, dass das Funkmodul 6 einschließlich der Antenne 18 vollständig im Feldgerätegehäuse 3 angeordnet und aufgenommen sein kann. Die Strahlungskopplung wird durch entsprechende Anordnung und Ausbildung der Antenne 18 und/oder des innenliegenden Leitungsabschnitts 9 der Anschlussleitung 5 realisiert. Die Feldkopplung 8 kann ohne zusätzliche Komponenten, insbesondere ohne spezielle Koppelschaltung (z. B. Schaltungsnetzwerke mit Widerständen, Kondensatoren, Spulen und dergleichen) realisiert werden.

Die Antenne 18 und der innenliegende Kopplungsabschnitt 9 der Anschlussleitung 5 können als parallel geführte Leiter oder parallelgeführte Leiterbahnen auf einer Leiterplatte ausgebildet sein, ohne zwingend auf eine solche Anordnung oder Ausbildung beschränkt zu sein.

In Fig. 3 ist die Feldkopplung 8 schematisch in Form einer kapazitiven Kopplung dargestellt. Hierbei beeinflussen sich die der beteiligten elektrischen/elektronischen Komponenten durch ein elektrisches Feld infolge einer Überkopplung auf parallel geführte Leiter in einem Kabel oder parallelgeführte Leiterbahnen auf einer Leiterplatte. Anstelle oder zusätzlich zur Antenne 18 aus Fig. 2 kann an den Datenfernübertragungsausgang des Funkmoduls 6 ein entsprechender Leiter angeschlossen sein, der zum innenliegenden Abschnitt 9 der Anschlussleitung 5 angeordnet ist. Leiter bzw. Antenne 8 können als Leiterbahn auf einer Leiterplatten ausgebildet sein, ebenfalls der innenliegende Leitungsabschnitt 9.

In Fig. 4 ist die Feldkopplung 8 schematisch in Form einer induktiven Kopplung dargestellt. Bei der induktiven Kopplung beeinflussen sich die beteiligten elektrischen/elektronischen Komponenten durch ein Magnetfeld. Die induktive Kopplung entsteht durch Magnetfeldeinkopplung, üblicherweise in Leiterschleifen, z. B. zwischen parallelgeführten Leiterschleifen. Anstelle oder zusätzlich zur Antenne 18 aus Fig. 2 kann an den Datenfernübertragungsausgang des Funkmoduls 6 eine entsprechende Leiterschleife angeschlossen sein, die entsprechend zum innenliegenden Abschnitt 9 der Anschlussleitung 5 angeordnet ist, die in entsprechender Weise auch als Leitschleife ausgebildet ist. Die Anordnung und Ausbildung als Leiterschleifen auf einer Leiterplatte sind ebenfalls möglich.

Das Funkmodul 6 kann in allen vorbeschriebenen Fällen eine in dem Gehäuse 3 angeordnete Antenne 18 aufweisen, wobei die Antenne 18 und der innerhalb des Gehäuses 3 liegende Abschnitt 9 der Anschlussleitung 5 für die wechselseitige Feldkopplung 8 ausgebildet und angeordnet sind. Bevorzugt ist das Funkmodul beispielsweise für die Verwendung von Funkübertragungstechniken wie beispielsweise NFC (Near Field Communication), RFID (Radio Frequency Identification), DECT (Digital Enhanced Cordless Telecommunications), Bluetooth, WiFi/WLAN o. ä. ausgebildet, ohne zwingend nur auf diese Techniken beschränkt zu sein. Andere Funkübertragungstechniken sind ebenfalls denkbar, sofern sie zur Feldkopplung 8 im Sinne der Erfindung verwendet werden können. Die Antenne 18 des Funkmoduls 6 ist bevorzugt vollständig in dem Gehäuse 3 aufgenommen. Die Antenne 18 und der innenliegende Abschnitt 9 der Anschlussleitung 5 können zum Beispiel als parallel geführte Leiter oder parallelgeführte Leiterbahnen auf einer Leiterplatte ausgebildet sein, wobei andere Ausgestaltungen und Anordnungen der Antenne 18 und des innenliegenden Leitungsabschnitts 9 ebenfalls möglich sind, sofern mit diesen die Feldkopplung 8 im erfindungsgemäßen Sinn erzielt wird.

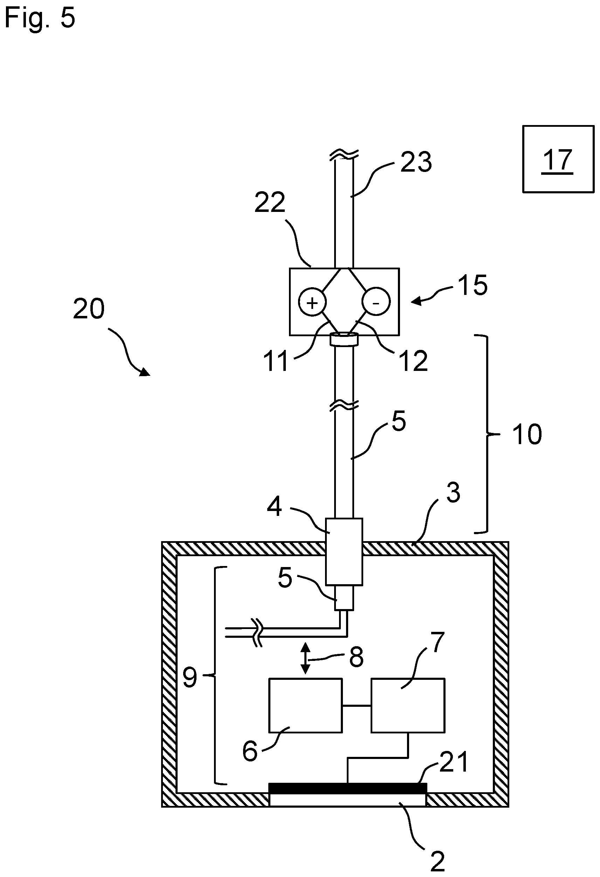

Fig. 5 stellt ein Funktionsdiagramm eines noch weiteren Ausführungsbeispiels eines Feldgeräts 20 gemäß der Erfindung dar. Das Feldgerät 20 kann grundsätzlich aufgebaut sein wie das Feldgerät 1 aus Fig. 1. Im Folgenden werden daher im Wesentlichen nur die Unterschiede des Feldgeräts 20 zum Feldgerät 1 erläutert.

Das Gehäuse 3 des in Fig. 5 dargestellten Feldgeräts 20 ist aus einem Metallwerkstoff gebildet. Der Messwertaufnehmer 2, zum Beispiel ein keramischer Druckaufnehmer, ist in einer Aussparung bzw. Fenster des Gehäuses 3 angeordnet. Auf der Gehäuseinnenseite weist der beim vorliegenden Ausführungsbeispiel an sich nicht metallische Messwertaufnehmer 2 gehäuseinnenseitig eine metallische Messelektrode 21 auf, die den Messwertaufnehmer 2 zum Innenraum des Gehäuses 3 teilweise oder vollständig belegt. Auf diese Weise kann eine optimale elektromagnetische Schirmwirkung des Feldgeräts 20 erzielt werden, die durch das Metallgehäuse 3 in Kombination mit der Metallelektrode 21 erzielt wird. Die Schirmwirkung kann zusätzlich zur Erhöhung des Wirkungsgrads der Feldkopplung 8 dienen, indem die Feldverteilung für die Feldkopplung 8 auf einen vorbestimmten Raumbereich konzentriert bzw. fokussiert wird.

Das freiliegende (nicht isolierte) Teilstück 15 der Anschlussleitung 5 ist bei dem in Fig. 5 gezeigten Ausführungsbeispiel des Feldgeräts 20 ein freies Ende der Anschlussleitung 5, das zum Beispiel in einem Anschluss- oder Klemmkasten 22 an eine weiterführende Leitung 23 (z. B. Versorgungsleitung) angeschlossen sein kann. An diesem Klemmkasten 22 kann das Datenübertragungssignal abgegriffen, d. h. vom Empfänger 17 empfangen werden, bzw. eingespeist werden, d. h. vom Sender 17 zum Funkmodul 6 gesendet werden.

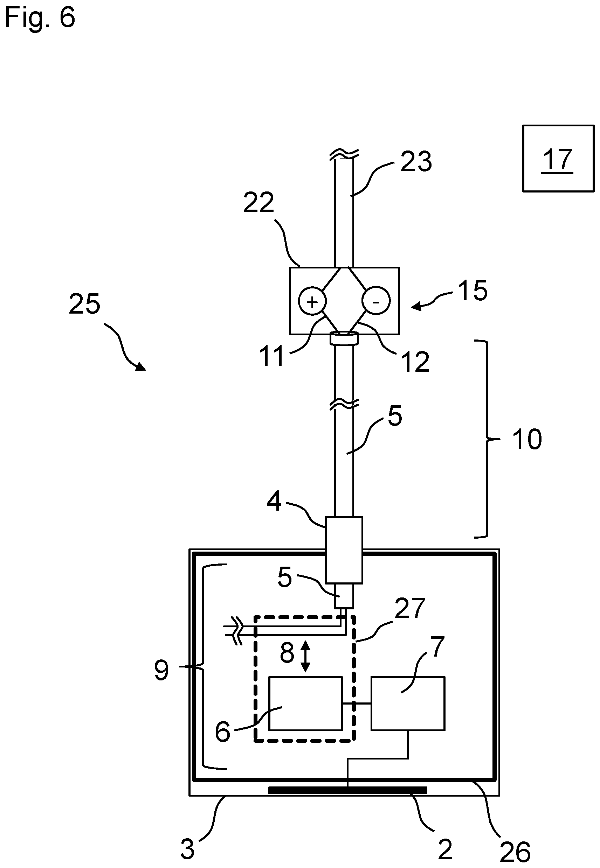

Fig. 6 stellt ein Funktionsdiagramm eines noch weiteren Ausführungsbeispiels eines Feldgeräts 25 gemäß der Erfindung dar. Das Feldgerät 25 kann grundsätzlich aufgebaut sein wie das Feldgerät 1 aus Fig. 1. Im Folgenden werden daher im Wesentlichen nur die Unterschiede des Feldgeräts 25 zum Feldgerät 1 dargestellt.

Das Gehäuse 3 des Feldgeräts 25 ist vorliegend aus einem Kunststoff (z. B. Polyvinylidenfluorid, PVDF) gebildet. Zur Verbesserung der elektromagnetischen Schirmwirkung weist das Gehäuse 3 eine elektromagnetisch wirksame Gehäuseschirmung 26 auf, die beispielsweise aus einer Metallschicht gebildet sein kann, die an dem Gehäuse 3 angebracht ist. Die Gehäuseschirmung 26 ist vorliegend an der Gehäuseinnenseite angebracht. Möglich ist die Anbringung der Gehäuseschirmung 26 alternativ oder zusätzlich auf der Gehäuseaußenseite oder eingebettet in die Gehäusewandungen. Die elektromagnetische Gehäuseschirmung 26 kann eine Konzentration des Feldes für die Feldkopplung bewirken. Die Gehäuseschirmung 26 kann ebenfalls das Einstrahlen von externen Störfeldern in das Gehäuse 3 bzw. den Gehäuseinnenraum unterbinden bzw. abschwächen.

In Fig. 6 ist ebenfalls dargestellt, dass zusätzlich oder alternativ zur Gehäuseschirmung 26 eine elektromagnetisch wirksame Gehäuseschirmung 27 näher am Ort der eigentlichen Feldkopplung 8 vorgesehen sein kann, um die Feldverteilung für die Feldkopplung weiter auf ein vorbestimmtes Raumvolumen zu konzentrieren/fokussieren. Eine derart ausgebildete und angeordnete Gehäuseschirmung 27 ist auch in Verbindung mit anderen Ausführungsbeispielen der Feldgeräte gemäß der Erfindung denkbar wie beispielsweise bei den in Fig. 1 bzw. 5 dargestellten Feldgeräten 1 und 20.

Das hierin offenbarte erfindungsgemäße Feldgerät sowie das erfindungsgemäße Datenübertragungsverfahren sind nicht auf die hierin jeweils beschriebenen konkreten Ausführungsformen beschränkt, sondern umfassen auch gleich wirkende weitere Ausführungsformen, die sich aus technisch sinnvollen weiteren Kombinationen der hierin beschriebenen Merkmale aller Erfindungsgegenstände ergeben. Insbesondere sind die vorstehend in der allgemeinen Beschreibung und der Figurenbeschreibung genannten und/oder in den Figuren allein gezeigten Merkmale und Merkmalskombinationen nicht nur in den jeweils hierin explizit angegebenen Kombinationen, sondern auch in anderen Kombinationen oder in Alleinstellung verwendbar, ohne den Rahmen der vorliegenden Erfindung zu verlassen. Beispielsweise kann das Datenfernübertragungssignal auf eine separate zusätzliche Ader der Anschlussleitung aufgekoppelt werden. Diese Ader kann ausschließlich für die Datenfernübertragung vorgesehen sein und ansonsten keine weitere elektrische Funktion erfüllen.

Es ist auch denkbar, das Funkmodul direkt in die Anschlussleitung zu integrieren. Das Funkmodul kann beispielsweise in den innenliegenden Abschnitt der Anschlussleitung integriert sein. Zum Beispiel kann das Funkmodul von einer Isolierung der Anschlussleitung umgeben und von dieser mit der Anschlussleitung mechanisch verbunden sein.

### Bezugszeichenliste

- 1: Feldgerät
- 2: Messwertaufnehmer
- 3: Gehäuse
- 4: Kabeldurchführung
- 5: Anschlussleitung
- 6: Funkmodul
- 7: Steuereinheit
- 8: Feldkopplung
- 9: Innenliegender Leitungsabschnitt
- 10: Außenliegender Leitungsabschnitt
- 11: Ader
- 12: Ader
- 13: Querwasserdichte Isolierung
- 14: Längswasserdichte Isolierung
- 15: Isolierungsfreies Teilstück
- 16: Isolierungsfreies Teilstück
- 17: Feldgeräteexterner Empfänger/Sender
- 18: Antenne
- 19: Medium
- 20: Feldgerät
- 21: Metallelektrode
- 22: Anschluss-/Klemmkasten
- 23: Weiterführende Leitung
- 25: Feldgerät
- 26: Gehäuseschirmung
- 27: Gehäuseschirmung

## Patentansprüche

1. Feldgerät (1, 20, 25), insbesondere Füllstand-, Grenzstand-, Durchfluss-, Druck- oder Temperaturmessgerät, mit einem Gehäuse (3), einer durch eine Kabeldurchführung (4) in das Gehäuse (3) geführten elektrischen Anschlussleitung (5) und einem im Gehäuse (3) aufgenommenen Funkmodul (6) zur Datenfernübertragung, wobei das Funkmodul (6) derart angeordnet und ausgebildet ist, ein Datenfernübertragungssignal vermittels einer Feldkopplung (8) mit einem im Gehäuse (3) liegenden Abschnitt (9) der Anschlussleitung (5) in einen außerhalb des Gehäuses (3) liegenden Abschnitt (10) der Anschlussleitung (5) zu übertragen und/oder von diesem zu empfangen, **dadurch gekennzeichnet, dass**
die Feldkopplung (8) als elektromagnetische Strahlungskopplung ausgebildet ist, wobei das Funkmodul (6) eine in dem Gehäuse (3) angeordnete Antenne (18) aufweist, wobei die Antenne (18) und der innerhalb des Gehäuses (3) liegende Abschnitt (9) der Anschlussleitung (5) für eine wechselseitige Feldkopplung (8) ausgebildet und angeordnet sind.

2. Feldgerät gemäß Anspruch 1,
**dadurch gekennzeichnet, dass**
der außerhalb des Gehäuses (3) liegende Abschnitt (10) der Anschlussleitung (5) eine quer- und/oder längswasserdichte Isolierung (13, 14) aufweist.

3. Feldgerät gemäß dem vorhergehenden Anspruch,
**dadurch gekennzeichnet, dass**
der außerhalb des Gehäuses (3) liegende Abschnitt (10) der Anschlussleitung (5) wenigstens ein isolierungsfreies Teilstück (15, 16) zur Auskopplung und/oder Einkopplung des Datenfernübertragungssignals aufweist.

4. Feldgerät gemäß einem der vorhergehenden Ansprüche,
**dadurch gekennzeichnet, dass**
das Gehäuse (3) eine elektromagnetisch wirksame Gehäuseschirmung (26, 27) aufweist.

5. Feldgerät gemäß einem der vorhergehenden Ansprüche,
**dadurch gekennzeichnet, dass**
das Gehäuse (3) aus einem Metallwerkstoff gebildet ist.

6. Feldgerät gemäß einem der vorhergehenden Ansprüche,
**dadurch gekennzeichnet, dass**
ein nichtmetallischer Messwertaufnehmer (2) gehäuseinnenseitig mit einer metallischen Messelektrode (21) belegt ist.

7. Feldgerät gemäß einem der vorhergehenden Ansprüche,
**dadurch gekennzeichnet, dass**
der außerhalb des Gehäuses (3) liegende Abschnitt (10) der Anschlussleitung (5) eine elektromagnetisch wirksame Leitungsschirmung aufweist.

8. Feldgerät gemäß einem der vorhergehenden Ansprüche,
**dadurch gekennzeichnet, dass**
der außerhalb des Gehäuses (3) liegende Abschnitt (10) der Anschlussleitung (5) eine Länge von wenigstens 2 m, bevorzugt wenigstens 3 m, noch bevorzugter wenigstens 5 m aufweist und die maximale Länge des außerhalb des Gehäuses (3) liegenden Abschnitts (10) der Anschlussleitung (5) höchstens 100 m bis 500 m beträgt, bevorzugt höchstens 50 m bis 100 m und noch bevorzugter höchstens 15 m bis 50 m.

9. Feldgerät gemäß einem der vorhergehenden Ansprüche,
**dadurch gekennzeichnet, dass**
die Anschlussleitung (5) als Tragkabel ausgebildet ist, an dem das Gehäuse (3) in betriebsgemäßem Zustand des Feldgeräts (1, 20, 25) hängend gehalten ist.

10. Verfahren zur Datenfernübertragung mittels eines in einem Gehäuse (3) eines Feldgeräts (1, 20, 25) aufgenommenen Funkmoduls (6) über eine durch eine Kabeldurchführung (4) in das Gehäuse (3) geführte elektrische Anschlussleitung (5), wobei ein Datenfernübertragungssignal vermittels einer Feldkopplung (8) des Funkmoduls (6) mit einem im Gehäuse (3) liegenden Abschnitt (9) der Anschlussleitung (5) in einen außerhalb des Gehäuses (3) liegenden Abschnitt (10) der Anschlussleitung (5) übertragen und/oder von diesem empfangen wird,
**dadurch gekennzeichnet, dass**
die Feldkopplung (8) durch elektromagnetische Strahlung zwischen einer in dem Gehäuse (3) angeordneten Antenne (18) und dem innerhalb des Gehäuses (3) liegenden Abschnitt (9) der Anschlussleitung (5), die für eine wechselseitige Feldkopplung (8) ausgebildet und angeordnet sind, ausgeführt wird.

11. Verfahren gemäß dem vorhergehenden Anspruch,
**dadurch gekennzeichnet, dass**
das Datenfernübertragungssignal an wenigstens einem Teilstück (15, 16) des außerhalb des Gehäuses (3) liegenden Abschnitts (10) der Anschlussleitung (5) durch galvanische, kapazitive und/oder induktive Kopplung und/oder durch elektromagnetische Strahlungskopplung ausgekoppelt und/oder eingekoppelt wird.

12. Verfahren gemäß einem der beiden vorhergehenden Ansprüche,
**dadurch gekennzeichnet, dass**
das Gehäuse (3) über die als Tragkabel ausgebildete Anschlussleitung (5) in betriebsgemäßem Zustand des Feldgeräts (1, 20, 25) hängend gehalten wird.

## Claims

1. A field device (1, 20, 25), in particular, a fill-level, point-level, flow, pressure or temperature-measurement device, with a housing (3), an electrical connection line (5) led into the housing (3) through a cable feedthrough (4), and a radio module (6) held in the housing (3) for remote data transmission, wherein the radio module (6) is arranged and designed in such a way as to transmit a remote data-transmission signal by means of a field coupling (8) with a section (9) of the connection line (5) located in the housing (3) into a section (10) of the connection line (5) located outside the housing (3) and/or received it from this,
**characterized in that**
the field coupling (8) is designed as electromagnetic radiation coupling, wherein the radio module (6) comprises an antenna (18) arranged in the housing (3), wherein the antenna (18) and the section (9) of the connection line (5) located within the housing (3) are designed and arranged for mutual field coupling (8).

2. The field device according to claim 1,
**characterized in that**
the section (10) of the connection line (5) located outside the housing (3) comprises transversely and/or longitudinally waterproof insulation (13, 14).

3. The field device according to the preceding claim,
**characterized in that**
the section (10) of the connection line (5) located outside the housing (3) comprises at least one insulation-free section (15, 16) for decoupling and/or coupling the data-transmission signal.

4. The field device according to one of the previous claims,
**characterized in that**
the housing (3) comprises an electromagnetically effective housing shield (26, 27).

5. Field device according to one of the preceding claims,
**characterized in that**
the housing (3) is made of a metal material.

6. Field device according to one of the preceding claims,
**characterized in that**
a non-metallic measurement transducer (2) is equipped with a metallic measuring electrode (21) on the inner side of the housing.

7. The field device according to one of the previous claims,
**characterized in that**
the section (10) of the connection line (5) outside the housing (3) comprises an electromagnetically effective line shielding.

8. The field device according to one of the previous claims,
**characterized in that**
the section (10) of the connection line (5) located outside the housing (3) has a length of at least 2 m, preferably at least 3 m, and even more preferably at least 5 m, and the maximum length of the section (10) of the connection line (5) located outside the housing (3) is not more than 100 m to 500 m, preferably not more than 50 m to 100 m and even more preferably, not more than 15 m to 50 m..

9. The field device according to one of the previous claims,
**characterized in that**
the connection line (5) is designed as a suspension cable on which the housing (3) is suspended when the field device (1, 20, 25) is in its operating state.

10. A method for remote data transmission by means of a radio module (6) held in a housing (3) of a field device (1, 20, 25) via an electrical connection line (5) via a cable feedthrough (4) into the housing (3) , wherein a remote data transmission signal is transmitted by means of a field coupling (8) of the radio module (6) with a section (9) of the connection line (5) located in the housing (3) into a section (10) of the connection line (5) located outside the housing (3) and/or is received by this.,
**characterized in that**
the field coupling (8) is carried out by electromagnetic radiation between an antenna (18) arranged in the housing (3) and the section (9) of the connection line (5) located in the housing (3), which are designed and arranged for mutual field coupling (8).

11. The method according to the preceding claim,
**characterized in that**
the remote data transmission signal is decoupled and/or coupled in at least one section (15, 16) of the section (10) of the connection line (5) located outside the housing (3) by galvanic, capacitive, and/or inductive coupling and/or by electromagnetic radiation coupling.

12. Method according to one of the two preceding claims,
**characterized in that**
when the field device (1, 20, 25) is in its operating state, the housing (3) is held suspended by the connection line (5) designed as a support cable.

## Revendications

1. Appareil de terrain (1, 20, 25), en particulier appareil de mesure de niveau, de niveau limite, de débit, de pression ou de température, comprenant un boîtier (3), un câble de raccordement (5) électrique guidé dans le boîtier (3) par un passage (4) de câble, et un module radio (6) logé dans le boîtier (3) pour la transmission à distance de données, dans lequel le module radio (6) est agencé et réalisé de manière à transmettre un signal de transmission à distance de données au moyen d'un couplage de champ (8) avec une partie (9) du câble de raccordement (5) située dans le boîtier (3) vers une partie (10) du câble de raccordement (5) située à l'extérieur du boîtier (3), et/ou à recevoir un tel signal de celle-ci,
**caractérisé en ce que**
le couplage de champ (8) est réalisé sous la forme d'un couplage de rayonnement électromagnétique, dans lequel le module radio (6) présente une antenne (18) disposée dans le boîtier (3), dans lequel l'antenne (18) et la partie (9) du câble de raccordement (5) située à l'intérieur du boîtier (3) sont formées et agencées pour un couplage de champ (8) mutuel.

2. Appareil de terrain selon la revendication 1,
**caractérisé en ce que**
la partie (10) du câble de raccordement (5) située à l'extérieur du boîtier (3) présente une isolation (13, 14) étanche à l'eau transversalement et/ou longitudinalement.

3. Appareil de terrain selon la revendication précédente,
**caractérisé en ce que**
la partie (10) du câble de raccordement (5) située à l'extérieur du boîtier (3) présente au moins une portion (15, 16) sans isolation pour l'extraction et/ou l'injection du signal de transmission à distance de données.

4. Appareil de terrain selon l'une quelconque des revendications précédentes,
**caractérisé en ce que**
le boîtier (3) présente un blindage (26, 27) de boîtier à effet électromagnétique.

5. Appareil de terrain selon l'une quelconque des revendications précédentes,
**caractérisé en ce que**
le boîtier (3) est formé d'un matériau métallique.

6. Appareil de terrain selon l'une quelconque des revendications précédentes,
**caractérisé en ce que**
un capteur (2) de mesure non métallique est doté d'une électrode (21) de mesure métallique à l'intérieur du boîtier.

7. Appareil de terrain selon l'une quelconque des revendications précédentes,
**caractérisé en ce que**
la partie (10) du câble de raccordement (5) située à l'extérieur du boîtier (3) présente un blindage de ligne à effet électromagnétique.

8. Appareil de terrain selon l'une quelconque des revendications précédentes,
**caractérisé en ce que**
la partie (10) du câble de raccordement (5) située à l'extérieur du boîtier (3) présente une longueur d'au moins 2m, de préférence d'au moins 3m, encore plus préférentiellement d'au moins 5m et la longueur maximale de la partie (10) du câble de raccordement (5) située à l'extérieur du boîtier (3) est de 100m à 500m au maximum, de préférence de 50m à 100m au maximum et encore plus préférentiellement de 15m à 50m au maximum.

9. Appareil de terrain selon l'une quelconque des revendications précédentes,
**caractérisé en ce que**
le câble de raccordement (5) est réalisé sous la forme d'un câble porteur auquel le boîtier (3) est maintenu suspendu dans un état de fonctionnement conforme de l'appareil de terrain (1, 20, 25).

10. Procédé de transmission à distance de données au moyen d'un module radio (6) logé dans un boîtier (3) d'un appareil de terrain (1, 20, 25) par l'intermédiaire d'un câble de raccordement (5) électrique guidé dans le boîtier (3) par un passage (4) de câble,
un signal de transmission à distance de données étant transmis au moyen d'un couplage de champ (8) du module radio (6) avec une partie (9) du câble de raccordement (5) située dans le boîtier (3) vers une partie (10) du câble de raccordement (5) située à l'extérieur du boîtier (3), et/ou un tel signal étant reçu par celle-ci,
**caractérisé en ce que**
le couplage de champ (8) est conçu par rayonnement électromagnétique entre une antenne (18) disposée dans le boîtier (3) et la partie (9) du câble de raccordement (5) située à l'intérieur du boîtier (3), qui sont réalisées et disposées pour un couplage de champ (8) alternatif.

11. Procédé selon la revendication précédente,
**caractérisé en ce que**
le signal de transmission à distance de données sur au moins une portion (15, 16) de la partie (10) du câble de raccordement (5) située à l'extérieur du boîtier (3) est extrait et/ou injecté par couplage galvanique, capacitif et/ou inductif et/ou par couplage électromagnétique par rayonnement.

12. Procédé selon l'une des deux revendications précédentes,
**caractérisé en ce que**
le boîtier (3) est maintenu suspendu par le câble de raccordement (5) réalisée sous la forme d'un câble porteur dans un état de fonctionnement conforme de l'appareil de terrain (1, 20, 25).
